# EUROPEAN PATENT SPECIFICATION

(11) **EP 1 093 022 B1**
(45) Date of publication and mention of the grant of the patent: **08.03.2006**
(21) Application number: 00308904.2
(22) Date of filing: 10.10.2000
(51) Int. Cl.: G03F 7/20, G01N 21/94

(54) **Lithographic projection apparatus**
Lithographischer Projektionsapparat
Appareil de projection lithographique

(30) Priority: 12.10.1999 EP 99203327
(43) Date of publication of application: 18.04.2001
(73) Proprietor: ASML Netherlands B.V., 5504 DR Veldhoven (NL)
(72) Inventor: van de Pasch, Engelbertus Antonius Fransiscus, 5688 RH Oirschot (NL); van Meer, Aschwin Lodewijk Hendricus Johannes, 4703 NE Roosendaal (NL); Klaassen, Franciscus Adrianus Gerardus, 5684 GH Best (NL)
(74) Representative: Leeming, John Gerard

(56) References cited:
- EP-A- 0 809 284
- US-A- 4 676 637
- US-A- 4 895 446
- US-A- 5 559 582
- US-A- 5 643 472
- US-A- 5 978 078
- PATENT ABSTRACTS OF JAPAN vol. 1999, no. 04, 30 April 1999 (1999-04-30) -& JP 11 016833 A (SAMSUNG ELECTRON CO LTD), 22 January 1999 (1999-01-22) -& US 6 198 982 B1 (YUN JONG-SOON ET AL) 6 March 2001 (2001-03-06)

## Description

The present invention relates to contamination detection means. More particularly, the invention relates to contamination detection means in a lithographic projection apparatus comprising:
- an illumination system for supplying a projection beam of radiation;
- a first object table for holding a mask;
- a second object table provided with a support surface for supporting and holding a substrate at its backside surface; and
- a projection system for imaging an irradiated portion of the mask onto a target portion of the substrate,

An apparatus of this type can be used, for example, in the manufacture of integrated circuits (ICs). In such a case, the mask (reticle) may contain a circuit pattern corresponding to an individual layer of the IC, and this pattern can then be imaged onto a target portion comprising one or more dies on a substrate (silicon wafer) that has been coated with a layer of radiation sensitive material (resist) on its top surface. In general, a single wafer will contain a whole network of adjacent target portions that are successively irradiated through the reticle, one at a time. In one type of lithographic projection apparatus, each target portion is irradiated by exposing the entire reticle pattern onto the target portion in one go; such an apparatus is commonly referred to as a wafer stepper. In an alternative apparatus ― which is commonly referred to as a step-and-scan apparatus ― each target portion is irradiated by progressively scanning the reticle pattern under the projection beam in a given reference direction (the "scanning" direction) while synchronously scanning the wafer table parallel or anti-parallel to this direction; since, in general, the projection system will have a magnification factor M (generally < 1), the speed *v* at which the wafer table is scanned will be a factor M times that at which the reticle table is scanned. More information with regard to lithographic devices as here described can be gleaned from International Patent Application

In general, apparatus of this type contained a single first object (mask) table and a single second object (substrate) table. However, machines are becoming available in which there are at least two independently movable substrate tables; see, for example, the multi-stage apparatus described in International Patent Applications WO 98/28665 and WO 98/40791. The basic operating principle behind such multi-stage apparatus is that, while a first substrate table is underneath the projection system so as to allow exposure of a first substrate located on that table, a second substrate table can run to a loading position, discharge an exposed substrate, pick up a new substrate, perform some initial metrology steps on the new substrate, and then stand by to transfer this new substrate to the exposure position underneath the projection system as soon as exposure of the first substrate is completed, whence the cycle repeats itself; in this manner, it is possible to achieve a substantially increased machine throughput, which in turn improves the cost of ownership of the machine.

Lithographic apparatus may employ various types of projection radiation, such as ultra-violet light (UV), extreme UV, X-rays, ion beams or electron beams, for example. Depending on the type of radiation used and the particular design requirements of the apparatus, the projection system may be refractive, reflective or catadioptric, for example, and may comprise vitreous components, grazing-incidence mirrors, selective multi-layer coatings, magnetic and/or electrostatic field lenses, *etc;* for simplicity, such components may be loosely referred to in this text, either singly or collectively, as a "lens". The apparatus may comprise components that are operated in vacuum, and are correspondingly vacuum-compatible.

When a substrate is loaded onto the support surface of the substrate table, the substrate may be sucked against the support surface applying a vacuum to a space between the support surface and the backside surface of the substrate. Using this method the substrate will take a form determined by the support surface. The support surface may be provided with a matrix arrangement of protrusions, substantially perpendicular to the support surface whereby the backside of the substrate is lying on a contact surface represented by a top part of the protrusions. The form of the substrate will then be determined by the contact surfaces that are all located in the same plane. If contamination particles are present in between the support surface and the backside surface of the substrate the form of the substrate is not determined only by the form of the support surface but also by the contamination particles. The contamination could cause an unacceptable deformation of the substrate, which may result in focus and overlay errors during imaging of the pattern in the mask onto a top surface of the substrate. The errors may result in a rejection of manufactured substrates and thus in a lower throughput of the lithographic apparatus, which leads to an increase in the cost of ownership.

US 5,559,582 discloses a lithographic apparatus having a cleaning tool for the substrate table. The cleaning tool comprises an abrasive whetstone and a dust free cloth.

It is an object of the invention to prevent focus and overlay errors caused by contamination particles present in between the support surface and the substrate backside surface. These and other objects are achieved in an apparatus as specified in appended claim 1.

By detecting the presence of contamination on the support surface one may initiate cleaning of the support surface such that focus and overlay errors caused by said contamination are anticipated. Fewer manufactured substrates will be rejected and the cost of ownership of the apparatus is improved.

In a first embodiment of the invention, said contamination detection means comprises:
- level sensing means constructed and arranged to detect a surface figure of a substrate positioned upon said support surface;
- data storage means for storing surface figures of at least two substrates; and
- processing means adapted to compare surface figures of at least two substrates stored in said data storage means so as to recognize a recurring deformation in the surface figures of said substrates at a similar location indicating the presence of contamination at that location on the support surface.

In this way level sensing means already present in the apparatus may be used for the detection of contamination present at the support surface. Such level sensing means may detect the surface figure of a substrate positioned upon said support surface and said surface figure may be used during exposure to adjust the height and tilt of the substrate such that the substrate will be positioned within the focal plane of the projection system. In case the surface figure of more than one substrate comprises a deformation at a similar location, said deformation indicates contamination of the support surface on said location because said contamination will deform every substrate positioned upon that support surface.

The contamination detection means is adapted to detect a location of contamination on said support surface and said apparatus comprises a cleaning tool adapted to move with respect to said support surface to said location and to clean said location. In this manner contamination detected on a particular location on said support surface may be cleaned in situ by the cleaning tool and a throughput penalty is avoided because opening, inspecting, cleaning and closing of the apparatus, which may cost a lot of time in which the apparatus is not operative, is prevented. In-situ cleaning of a particular contaminated location has the further advantage that it is not necessary to clean the whole support surface, causing wear of the cleaning tool and of the support surface.

The cleaning tool comprises a cleaning block having a cleaning surface and is further constructed and arranged to be positioned with its cleaning surface against said support surface and to be movable with respect to and in a plane parallel to the support surface when positioned against said support surface. Such a cleaning tool is very effective in removing contamination by abrasive cleaning of the support surface. The cleaning tool and the second object table may be constructed and arranged such that the support surface is moved and the cleaning block is held stationary against the contaminated location or such that the cleaning block is moved while the second object table is held stationary. It may also be advantageously to move both the second object table and the cleaning block. The cleaning block comprises a ceramic material, for example, alumina and titanium oxide. The cleaning block may be at least partially electrically conductive, such that a statical electrical charge will not accumulate upon the cleaning block and support surface. Attraction caused by such an electrical charge between the support surface and the cleaning block will then not occur. The roughness of the cleaning surface is advantageously 0. 1µm or less. The roughness is defined as the mean value of the absolute distances between the actual surface figure of the cleaning surface and the average surface figure of the cleaning surface. Such a roughness will be enough for cleaning of the contamination but will not damage the support surface.

The invention also relates to a device manufacturing method as defined in appended claim 6.

In a manufacturing process using a lithographic projection apparatus, a pattern in a mask is imaged onto a substrate which is at least partially covered by a layer of radiation sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, *e*.*g*. an IC. Such a patterned layer may then undergo various processes such as etching, ion-implantation (doping), metallization, oxidation, chemo-mechanical polishing, *etc*., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, *etc.* Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

Although specific reference has been made hereabove to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, *etc*. The skilled artisan will appreciate that, in the context of such alternative applications, any use of the terms "reticle", "wafer" or "die" in this text should be considered as being replaced by the more general terms "mask", "substrate" and "target portion", respectively.

The invention and its attendant advantages will be further elucidated with the aid of exemplary Embodiments and the accompanying schematic drawings, wherein:
Figure 1 schematically depicts a lithographic projection apparatus suitable for implementation of the present invention;
Figure 2 schematically depicts contamination detection means according to a first embodiment of the invention;
Figures 3a and 3b schematically depict a cleaning tool according to the first embodiment of the invention; and
Figure 3c schematically depicts a substrate cleaning tool according to a second embodiment of the invention.

### Embodiment 1

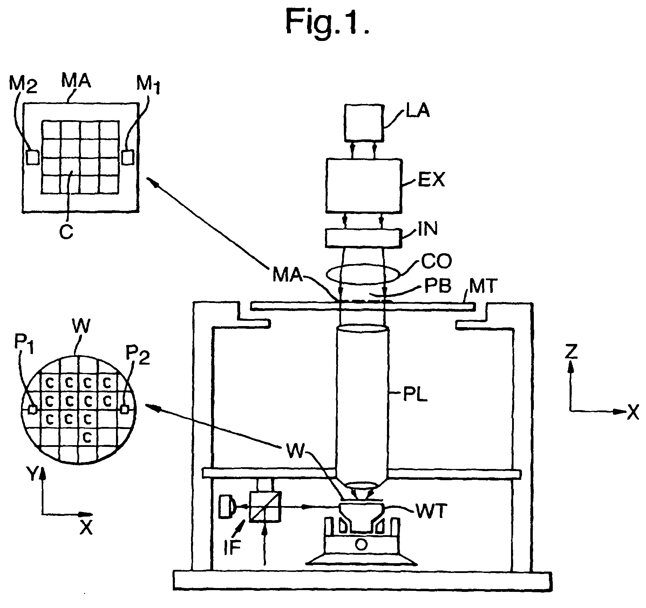

Figure 1 schematically depicts a lithographic projection apparatus suitable for implementation of the invention. The apparatus comprises:
- a radiation system LA, Ex, IN, CO for supplying a projection beam PB of radiation (e.g. UV or EUV radiation, X-ray, ions, or electrons);
- a first object table (mask table) MT provided with a mask holder for holding a mask MA (*e*.*g*. a reticle);
- a second object table (substrate table) WT provided with a support surface for holding a substrate W (*e.g.* a resist-coated silicon wafer) at its backside surface; and
- a projection system PL (*e.g.* a lens or catadioptric system, or a mirror group) for imaging an irradiated portion of the mask MA onto a target portion C of the substrate W.

In this case, the depicted apparatus comprises refractive components. However, it may alternatively comprise one or more reflective components.

The radiation system comprises a source LA (*e*.*g*. a Hg lamp or excimer laser, a thermionic gun or ion source, or a wiggler/undulator situated around the path of an electron beam in a storage ring or synchrotron) which produces a beam of radiation. This beam is passed along various optical components, ― *e*.*g*. beam shaping optics Ex, an integrator IN and a condensor CO ― so that the resultant beam PB has the desired shape and intensity distribution throughout its cross-section.

The beam PB subsequently intercepts the mask MA which is held in a mask holder on a mask table MT. Having passed through the mask MA, the beam PB passes through the projection system PL, which focuses the beam PB onto a target portion C of the substrate W. With the aid of the interferometric displacement and measuring means IF, the substrate table WT can be moved accurately, *e*.*g*. so as to position different target portions C in the path of the beam PB.

The depicted apparatus can be used in two different modes:
- In step mode, the mask table MT is kept essentially stationary, and an entire mask image is projected in one go (*i*.*e*. a single "flash") onto a target portion C. The substrate table WT is then shifted in the x and/or y directions so that a different target portion C can be irradiated by the (stationary) beam PB;
- In scan mode, essentially the same scenario applies, except that a given target portion C is not exposed in a single "flash". Instead, the mask table MT is movable in a given direction (the so-called "scan direction", *e.g.* the x direction) with a speed v, so that the projection beam PB is caused to scan over a mask image; concurrently, the substrate table WT is simultaneously moved in the same or opposite direction at a speed *V =* Mv, in which *M* is the magnification of the projection system PL (typically, M = 1/4 or 1/5). In this manner, a relatively large target portion C can be exposed, without having to compromise on resolution.

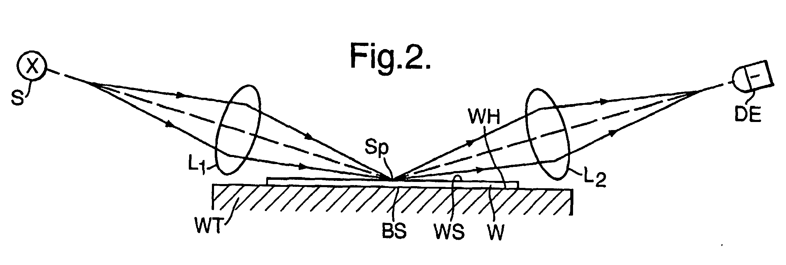

Figure 2 shows a side-view of the substrate table WT of figure 1, and the contamination detection means according to a first embodiment of the invention. Said contamination detection means is provided with level sensing means comprising a source of radiation S, a lens system L1, L2 and a detector DE. The level sensing means is used to detect a surface figure of the top surface WS of a substrate W held with its backside BS on a support surface WH of a substrate table WT. When the level sensing means is used the source of radiation S produces a beam of radiation which is directed with a lens L1 into a spot SP reflected at the top surface WS of the substrate W and subsequently directed through the lens L2 to the detector DE. The detector is constructed and arranged to measure a change in the direction of the beam, indicating a deformation of the surface figure of the top surface WS of the substrate W. Such a deformation may be caused by the substrate W being thicker at a particular location or by contaminants present between the backside surface BS of the substrate W and the support surface WH. By storing the surface figures of at least two substrates in data storage means and by comparing those surface figures, a recurring deformation in the surface figures at a similar location can be detected. This will indicate a contamination of the support surface WH at said location. The level sensing means may be a focus detection system as described in US 5,191,200.

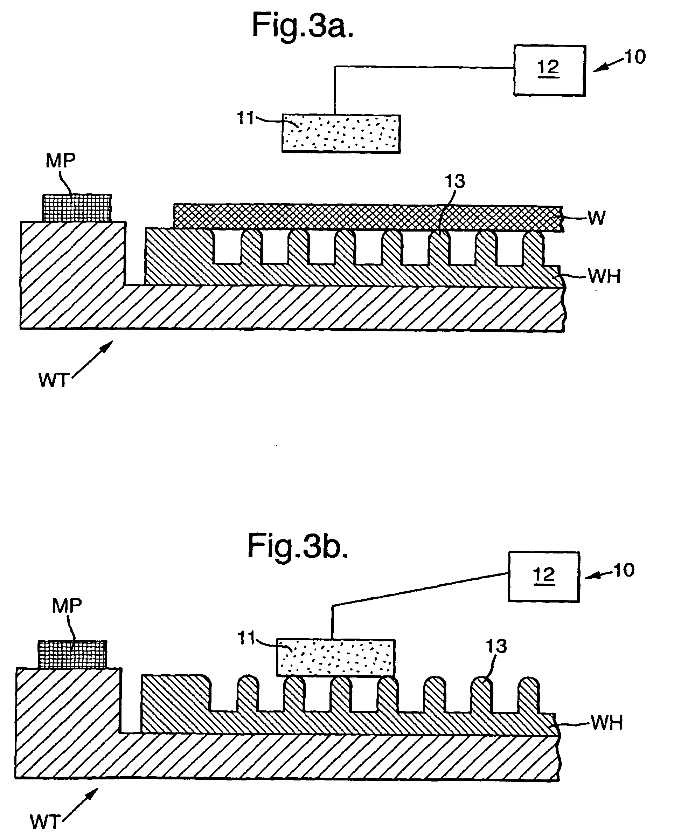

Figure 3a partly shows in cross-section the substrate table WT of figure 1 and a substrate table cleaning tool 10 according to the first embodiment of the invention. The substrate table WT is provided with a support surface WH comprising a matrix arrangement of protrusions 13 substantially perpendicular to that surface. A vacuum is created in the region in between the various protrusions 13 and the backside of the substrate W for holding the substrate W on the support surface WH. A contamination particle present in between a protrusion 13 and the backside surface of the substrate W will cause a deformation of the substrate W and thus of its top surface on which a pattern is to be imaged. The protrusions 13 exhibit a relatively small contact surface to the backside surface of the substrate W, resulting in a low probability of contamination being present in between the support surface WH and the substrate W. Another advantage of a relatively small contact surface is that the pressure from the backside surface on the contact surface is relatively high compared to when a larger contact surface is used. The higher pressure may crush any contamination present on the support surface.

The support surface WH may be cleaned in between unloading of a substrate from and loading of another substrate W onto the substrate table WT when contamination present on the support surface WH is detected. During cleaning of the support surface WH a cleaning block 11 of the wafer holder cleaning tool 10 is lowered onto the protrusions 13 of the support surface WH by a cleaning block drive unit 12, as is shown in figure 3b. Subsequently, either the cleaning block 11 or the wafer table WT (or both) will be translated such that the cleaning block 11 moves over the support surface WH. Contamination present on one or more of the protrusions 13 will be wiped off by abrasive cleaning. The cleaning operation may be automated and is performed without opening the lithographic apparatus, which will considerably lower the down time and considerably increase the throughput of the apparatus.

The cleaning block 11 of the embodiment shown comprises a ceramic material which is electrically conductive, such as, for instance, alumina or titanium oxide having a metal as an additive. The cleaning block 11 is electrically connected to ground potential to prevent the build up of an electrostatic charge during the cleaning operation. Such a build up of electrostatic charge may cause an electrostatic attraction between the support surface WH and the cleaning block 11.

Further, the cleaning surface of the cleaning block 11 has a surface roughness in the order of 0.1 µm or less to equally distribute the contact force exerted by the cleaning block 11 over the various protrusions 13 which are in contact with the cleaning block 11, and to prevent an excessive force being exerted on a single protrusion. Such an excessive force could damage a protrusion 13 and therefore damage the evenness of the contact surface presented by the top parts of the protrusions.

Figures 3a and 3b show a marker plate MP present on the topside of the substrate table WT next to the protrusions of the support surface WH. The marker incorporated in the marker plate MP is used for an alignment procedure for the substrate W and substrate table WT in the lithographic apparatus. The topside of the marker plate MP is about in the same plane as the topside of a substrate W present on the substrate table WT. During a cleaning operation of the protrusions of the support surface, in which case the substrate W is absent as is shown in figure 2b, the cleaning block 11 may run into the marker plate MP or any other further tool which may be present on the topside of the substrate table WT. To prevent the marker plate MP from being damaged the cleaning tool 10 is constructed such that the cleaning block 11 is retracted from the protrusions when a preset value of a force exerted on the marker plate MP or any other tool it may run into is exceeded.

### Embodiment 2

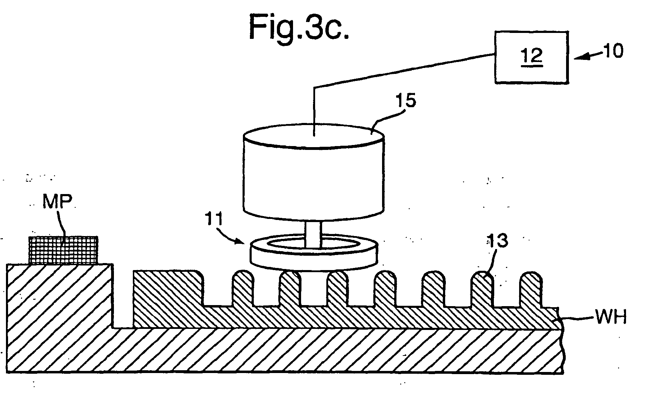

Figure 3c shows a cleaning tool 10 according to a second embodiment of the invention for use in the apparatus of figure 1. The second embodiment utilizes the contamination detection means of the present invention described above, together with certain refinements to the cleaning tool described below. In the cleaning tool 10 the rotation unit 15 may rotate the cleaning block 11 such that by the rotary movement of the cleaning block 11 abrasive cleaning of the support surface WH occurs. The cleaning block driving unit 12 may be used to locate the cleaning block 11 at a particular location on the support surface WH. Abrasive cleaning will be improved by the rotary movement of the cleaning block 11.

Whilst specific embodiments of the invention are disclosed above it will be appreciated that the invention may be practiced other than described. The invention is defined by the claims.

## Claims

1. A lithographic projection apparatus comprising:
• an illumination system (IL) for supplying a projection beam (PB) of radiation;
• a first object table (MT) for holding a mask (MA);
• a second object table (WT) provided with a support surface (WH) for supporting and holding a substrate (W); and
• a projection system (PL) for imaging an irradiated portion of the mask (MA) onto a target portion (c) of the substrate (w);
• contamination detection means (S, L1, L2, DE) constructed and arranged to detect a location of contamination on the support surface (WH) of the second object table (WT), and
• a cleaning tool (10) adapted to move with respect to said support surface (WH) to said location of contamination and to clean said location, said cleaning tool comprising a cleaning block (11) having a cleaning surface;
arranged to means (12) position said cleaning surface against said support surface (WH), such that said cleaning block (11) is movable with respect and parallel to said support surface (WH) when positioned against said support surface (WH), **characterised in that**:
• the cleaning block (11) comprises a ceramic material.

2. Apparatus according to claim 1, wherein the ceramic material is selected from the group consiting of alumina and titanium oxide.

3. Apparatus according to claim 1 or 2, wherein the cleaning block (11) is at least partially electrically conductive.

4. Apparatus according to any one of the claims 1 to 3, wherein the cleaning surface of the cleaning block (11) has a surface roughness of 0.1µm or less.

5. Apparatus according to claim 1, wherein said contamination detection means comprises:
• a level sensing means (S, L1, L2, DE) constructed and arranged to detect a surface figure of a substrate positioned upon said support surface (WH);
• data storage means for storing surface figures of at least two substrates; and
• processing means adapted to compare surface figures of at least two substrates stored in said data storage means so as to recognize a recurring deformation in the surface figures of said substrates at a similar location indicating the presence of contamination at that location on said support surface (WH).

6. A device manufacturing method comprising the steps of:
• providing a substrate (W) which is at least partially covered by a layer of radiation-sensitive material to a substrate table (WT) provided with a support surface (WH), for holding and supporting the substrate (w);
• providing a mask (MA) which contains a pattern;
• using a projection beam (PB) of radiation to project an image of at least a portion of the mask pattern via a projection system (PL) onto a target portion (C) of the layer of radiation-sensitive material; and
• detecting a location of contamination on the support surface (WH) of the substrate table (WT);
• moving a cleaning tool (10) comprising a cleaning block (11) to said location;
• cleaning said location by moving a cleaning surface of said cleaning block (11) parallel to said support surface (WH); **characterised in that**:
• said cleaning block (11) comprises a ceramic material.

## Patentansprüche

1. Eine lithographische Projektionsvorrichtung, aufweisend:
ein Beleuchtungssystem (IL) zum Liefern eines Projektionsstrahls (PB) einer Strahlung;
einen ersten Objekttisch (MT) zum Halten einer Maske (MA);
einen zweiten Objekttisch (WT), der mit einer Lagerfläche (WH) zum Lagern und Halten eines Substrats (W) versehen ist; und
ein Projektionssystem (PL) zum Abbilden eines bestrahlten Abschnittes der Maske (MA) auf einen Zielabschnitt (C) des Substrats (W);
eine Verunreinigungserkennungsvorrichtung (S, L1, L2, DE), die zur Erkennung des Orts einer Verunreinigung der Lagerfläche (WH) des zweiten Objekttisches (WT) aufgebaut und angeordnet ist; und
ein Reinigungswerkzeug (10), welches sich bezüglich der Lagerfläche (WH) zu dem Ort der Verunreinigung zu bewegen vermag und besagten Ort reinigt, wobei das Reinigungswerkzeug einen Reinigungsblock (11) mit einer Reinigungsoberfläche aufweist;
Mittel (12), welche dafür angeordnet sind, die Reinigungsoberfläche gegenüber der Lagerfläche (WH) derart zu positionieren, dass der Reinigungsblock (11) beweglich bezüglich und parallel zu der Lagerfläche (WH) ist, wenn er gegenüber der Lagerfläche (WH) positioniert ist, **dadurch gekennzeichnet, dass**:
der Reinigungsblock (11) ein Keramikmaterial aufweist.

2. Vorrichtung nach Anspruch 1, wobei das Keramikmaterial ausgewählt ist aus der Gruppe bestehend aus Aluminiumoxid und Titanoxid.

3. Vorrichtung nach Anspruch 1 und 2, wobei der Reinigungsblock (11) zumindest teilweise elektrisch leitfähig ist.

4. Vorrichtung nach einem der Ansprüche 1 bis 3, wobei die Reinigungsoberfläche des Reinigungsblocks (11) eine Oberflächenrauigkeit von 0,1 µm oder weniger hat.

5. Vorrichtung nach Anspruch 1, wobei die Verunreinigungserkennungsvorrichtung aufweist:
eine Pegelsensierungsvorrichtung (S, L1, L2, DE), welche zur Erkennung einer Oberflächenformung eines Substrates aufgebaut und angeordnet ist, welches auf der Lagerfläche (WH) angeordnet ist;
Datenspeichermittel zur Speicherung von Oberflächenformungen wenigstens zweier Substrate; und
Verarbeitungsmittel, die Oberflächenformungen wenigstens zweier Substrate zu vergleichen vermögen, die in den Datenspeichermitteln gespeichert sind, um eine wiederkehrende Verformung in den Oberflächenformungen der Substrate an ähnlichen Orten zu erkennen, was das Vorhandensein einer Verunreinigung an diesem Ort der Lagerfläche (WH) anzeigt.

6. Ein Vorrichtungsherstellungsverfahren, aufweisend die Schritte von:
Bereitstellen eines Substrats (W), welches zumindest teilweise mit einer Schicht eines strahlungsempfindlichen Materials bedeckt ist, an einem Substrattisch (WT), der mit einer Lagerfläche (WH) zum Halten und Lagern des Substrates (W) versehen ist;
Bereitstellen einer Maske (MA), welche ein Muster enthält;
Verwenden eines Projektionsstrahls (PB) einer Strahlung, um ein Bild wenigstens eines Teils des Maskenmusters über ein Projektionssystem (PL) auf einen Zielabschnitt (C) der Schicht aus strahlungsempfindlichen Material zu projizieren; und
Erkennen eines Orts einer Verunreinigung auf der Oberfläche (WH) des Substrattisches (WT);
Bewegen eines Reinigungswerkzeugs (10), das einen Reinigungsblock (11) aufweist, an den Ort;
Reinigen des Ortes durch Bewegen einer Reinigungsoberfläche des Reinigungsblocks (11) parallel zu der Lagerfläche (WA), **dadurch gekennzeichnet, dass**:
der Reinigungsblock (11) ein Keramikmaterial aufweist.

## Revendications

1. Appareil de projection lithographique comportant :
• un système d'éclairage (IL) pour délivrer un faisceau de projection (PB) de rayonnement ;
• une première table d'objet (MT) pour porter un masque (MA) ;
• une seconde table d'objet (WT) munie d'une surface de support (WH) pour supporter et porter un substrat (W) ; et
• un système de projection (PL) pour reproduire une partie irradiée du masque (MA) sur une partie cible (C) du substrat (W) ;
• des moyens de détection de contamination (S, L1, L2, DE) construits et agencés pour détecter un emplacement de contamination sur la surface de support (WH) de la seconde table d'objet (WT) ; et
• un outil de nettoyage (10) adapté pour se déplacer par rapport à ladite surface de support (WH) vers ledit emplacement de contamination et pour nettoyer ledit emplacement, ledit outil de nettoyage comportant un bloc de nettoyage (11) ayant une surface de nettoyage ; des moyens (12) agencés pour positionner ladite surface de nettoyage contre ladite surface de support (WH), de telle sorte que ledit bloc de nettoyage (11) soit mobile par rapport à ladite surface de support (WH), et parallèlement à celle-ci, lorsqu'il est positionné contre ladite surface de support (WH), **caractérisé en ce que** :
• le bloc de nettoyage (11) comporte un matériau céramique.

2. Appareil selon la revendication 1, dans lequel le matériau céramique est sélectionné parmi le groupe constitué d'alumine et d'oxyde de titane.

3. Appareil selon la revendication 1 ou 2, dans lequel le bloc de nettoyage (11) est au moins partiellement électriquement conducteur.

4. Appareil selon l'une quelconque des revendications 1 à 3, dans lequel la surface de nettoyage du bloc de nettoyage (11) a une rugosité de surface de 0,1 µm ou moins.

5. Appareil selon la revendication 1, dans lequel lesdits moyens de détection de contamination comportent :
• des moyens de détection de niveau (S, L1, L2, DE) construits et agencés pour détecter un schéma de surface d'un substrat positionné sur ladite surface de support (WH) ;
• des moyens de mémorisation de données pour mémoriser des schémas de surface d'au moins deux substrats ; et
• des moyens de traitement adaptés pour comparer des schémas de surface d'au moins deux substrats mémorisés dans lesdits moyens de mémorisation de données de manière à reconnaître une déformation récurrente des schémas de surface desdits substrats à un emplacement similaire indiquant la présence d'une contamination à cet emplacement sur ladite surface de support (WH).

6. Procédé de fabrication de dispositif comportant les étapes consistant à :
• prévoir un substrat (W) qui est au moins partiellement recouvert d'une couche de matériau sensible au rayonnement sur une table de substrat (WT) munie d'une surface de support (WH), pour porter et supporter le substrat (W) ;
• fournir un masque (MA) qui contient un motif ;
• utiliser un faisceau de projection (PB) de rayonnement pour projeter une image d'au moins une partie du motif de masque via un système de projection (PL) sur une partie cible (C) de la couche de matériau sensible au rayonnement ; et
• détecter un emplacement de contamination sur la surface de support (WH) de la table de substrat (WT) ;
• déplacer un outil de nettoyage (10) comportant un bloc de nettoyage (11) vers ledit emplacement ;
• nettoyer ledit emplacement en déplaçant une surface de nettoyage dudit bloc de nettoyage (11) parallèlement à ladite surface de support (WH) ; **caractérisé en ce que** :
• ledit bloc de nettoyage (11) comporte un matériau céramique.
